# EUROPÄISCHE PATENTSCHRIFT

(11) **EP 3 958 297 B1**
(45) Veröffentlichungstag und Bekanntmachung des Hinweises auf die Patenterteilung: **04.10.2023**
(21) Anmeldenummer: 20191459.5
(22) Anmeldetag: 18.08.2020
(51) Int. Cl.: H01L 21/683, H01L 21/687

(54) **VERFAHREN ZUM HERSTELLEN EINES VAKUUMGREIFERS FÜR HALBLEITERWERKSTÜCKE UND VAKUUMGREIFER**
VACUUM GRIPPER AND METHOD FOR MANUFACTURING A VACUUM GRIPPER FOR SEMICONDUCTOR WORKPIECES
PROCÉDÉ DE FABRICATION D'UN PRÉHENSEUR À VIDE POUR PIÈCES SEMI-CONDUCTRICES ET PRÉHENSEUR À VIDE

(43) Veröffentlichungstag der Anmeldung: 23.02.2022
(73) Patentinhaber: Siltronic AG, 81677 München (DE)
(72) Erfinder: Lamprecht, Ludwig, 83376 Truchtlaching (DE); Geißler, Sebastian, 09618 Brand-Erbisdorf (DE)

(56) Entgegenhaltungen:
- JP-A- 2019 016 700
- US-A1- 2016 181 142
- US-A1- 2017 345 692
- US-A1- 2018 005 863
- US-A1- 2018 259 855
- US-A1- 2019 080 954
- US-A1- 2019 272 982
- US-B1- 10 707 652

## Beschreibung

Die vorliegende Erfindung betrifft ein Verfahren zum Herstellen eines Vakuumgreifers für Halbleiterwerkstücke sowie einen solchen Vakuumgreifer für Halbleiterwerkstücke.

### Stand der Technik

Bei der Herstellung und Bearbeitung von Halbleiterwerkstücken wie z.B. Scheiben (oder Wafer) aus Silizium oder anderen Halbleitermaterialien werden Vakuumgreifer, oftmals auch als "Chuck" oder auch Sauggreifer oder Vakuumsauggreifer bezeichnet, verwendet, um diese Halbleiterwerkstücke während verschiedener Prozessschritte fixieren und/oder transportieren und/oder in bestimmter Ausrichtung halten zu können. Zugleich werden die Halbleiterwerkstücke aber auch, wenn sie auf einem Vakuumgreifer angeordnet bzw. gehalten sind, bearbeitet. Dies umfasst z.B. das Polieren, Ätzen, Reinigen, Vermessen und Schleifen der Oberflächen.

Solche Vakuumgreifer für Halbleiterwerkstücke können als gegossene, geschweißte und mittels spanabhebender Bearbeitungsverfahren bearbeitete Vorrichtungen angefertigt werden. Durch diese Fertigungsverfahren sind, wie sich gezeigt hat, Formgebung und Funktionsmerkmale der Vakuumgreifer allerdings nur eingeschränkt realisierbar.

So offenbart die Schrift US 2019/272982 A1 ein Verfahren zum Herstellen eines Vakuumgreifers für Halbleiterwerkstücke, bei dem der Vakuumgreifer aus zumindest einem Grundmaterial mittels eines additiven Aufbauverfahrens erzeugt wird.

Die Schrift US 2019/080954 A1 offenbart eine Vorrichtung zum Halten einer Halbleiterscheibe unter Verwendung von Vakuum.

Auch die Schrift US 2017/345692 A1 offenbart eine Vorrichtung zum Halten einer Halbleiterscheibe unter Verwendung von Vakuum, die mittels 3D Druck hergestellt wurde.

Es besteht daher Bedarf an verbesserten Vakuumgreifern für Halbleiterwerkstücke bzw. deren Herstellung.

### Offenbarung der Erfindung

Erfindungsgemäß werden ein Verfahren zum Herstellen einer Vorrichtung, die geeignet ist mittels Vakuum ein Halbleiterwerkstück festzuhalten vorgeschlagen. Vorteilhafte Ausgestaltungen sind Gegenstand der Unteransprüche sowie der nachfolgenden Beschreibung.

Die Erfindung beschäftigt sich mit der Herstellung eines Vakuumgreifers für Halbleiterwerkstücke wie z.B. Siliziumwafer, und damit auch dessen konstruktionstechnischer Gestaltung. Bei einem Vakuumgreifer handelt es sich, wie eingangs auch schon erwähnt, um eine Vorrichtung, mittels welcher ein Halbleiterwerkstück, insbesondere ein Wafer (also z.B. eine Scheibe), sicher festgehalten werden kann. Hierzu wird - wie der Name schon sagt - ein Vakuum erzeugt, mittels dessen das Halbleiterwerkstück am Vakuumgreifer sozusagen angesaugt werden kann.

Ein solcher Vakuumgreifer weist bevorzugt eine (zumindest im Wesentlichen) ebene Fläche, auf der ein Halbleiterwerkstück anordenbar ist, eine oder mehrere Ansaugöffnungen und einen oder mehrere damit verbundene Kanäle auf. Diese Kanäle sollten dann entsprechend in Verbindung mit den Ansaugöffnungen stehen. Die Ansaugöffnungen wiederum sollten möglichst im Bereich der ebenen Fläche vorgesehen sein, sodass das Halbleiterwerkstück darauf positioniert werden kann. Im Übrigen sollten die Kanäle dann mit einer Unterdruckquelle verbunden werden können oder verbunden sein, um einen Unterdruck - bzw. ein Vakuum - in den Kanälen erzeugen zu können. Die ebene Fläche kann z.B. eine runde Form aufweisen, damit typische Wafer darauf platziert werden können. Ein Durchmesser dieser runden Fläche oder des gesamten Vakuumgreifers kann dann z.B. 300 mm oder auch mehr betragen.

Bei dem vorgeschlagenen Verfahren wird aus zumindest einem Grundmaterial mittels eines additiven Aufbau- bzw. Herstellungsverfahrens - hierbei kann es sich insbesondere um einen sog. 3-D-Druck handeln - ein Vakuumgreifer erzeugt, und zwar insbesondere in bzw. mit einer vorgegebenen Form. Es wird also z.B. das Grundmaterial Schicht für Schicht aufeinander gefügt, bis letztlich die gewünschte, vorgegebene Form entstanden ist. Bevorzugt wird der Vakuumgreifer dabei derart ausgebildet, dass er die zumindest im Wesentlichen ebene Fläche, eine oder mehrere Ansaugöffnungen und einen oder mehrere damit verbundene Kanäle aufweist, wie sie vorstehend schon als zweckmäßige Ausgestaltungen eines Vakuumgreifers erläutert wurden.

Bevorzugt wird der Vakuumgreifer außerdem derart ausgebildet, dass er Verstärkungsstrukturen umfasst, die insbesondere aus dem Grundmaterial gebildet werden. Das Erzeugen solcher Verstärkungsstrukturen wie z.B. Verstrebungen, Verdickungen und Ähnliches kann mittels des additiven Aufbauverfahrens bzw. mittels 3-D-Druck besonders einfach und auch in bzw. mit mehr oder weniger beliebiger Form möglich. Verstärkungsstrukturen können aber auch aus einem anderen Material gebildet werden, das z.B. eine andere Materialhärte als das Grundmaterial aufweist.

Vorzugsweise wird das Grundmaterial mit zumindest einem Additiv versetzt, womit eine Anpassung der Materialhärte erreicht werden kann. Damit lassen sich - ähnlich wie bei den Verstärkungsstrukturen - die mechanischen Eigenschaften des Vakuumgreifers gezielt beeinflussen, insbesondere auch selektiv an bestimmten Stellen oder in bestimmten Bereichen, z.B. auch für die Bildung der Verstärkungsstrukturen.

Ebenso ist es zweckmäßig, wenn vorgegebene Bereiche des Vakuumgreifers aus einem anderen Material als dem Grundmaterial mittels des additiven Aufbauverfahrens erzeugt werden. So können z.B. flexible Bereiche hergestellt werden, die z.B. als Dichtung fungieren.

In diesem Zusammenhang ist es ebenso bevorzugt, wenn auf der dem Halbleiterwerkstück zuzuwendenden Fläche oder Seite des Vakuumgreifers eine Schicht mit einem Material von geringerer Härte bzw. einem geringeren Härtegrad als dem Grundmaterial gebildet wird. Diese Schicht kann dann die ebene Fläche aufweisen. Diese Schicht kann dann dazu dienen, etwaige Beschädigungen am Halbleiterwerkstück zu vermeiden und somit als Ersatz für ein sog. "Chuck Pad" dienen. Bei einem solchen "Chuck Pad" handelt es sich herkömmlicherweise um eine Art Gewebe- oder Textil-Stück, ggf. auch aus Polyurethan, das auf die - bei herkömmlichen Vakuumgreifern - harte Oberfläche gelegt wird, um Beschädigungen am Halbleiterwerkstück zu vermeiden. Ein solches ist bei Ausbildung der erwähnten Schicht nicht mehr nötig.

Anschließend, also nachdem der Vakuumgreifer mit der vorgegebenen Form aus dem Grundmaterial oder ggf. den weiteren Materialien hergestellt worden ist, kann vollständig oder in vorbestimmten Bereichen einer Oberfläche des (auf diese Weise aufgebauten) Körpers ein Beschichtungsmaterial zum Schutz gegen Chemikalien aufgebracht werden, d.h. der Vakuumgreifer wird mittels einer Beschichtung (die als Schutzschicht dient) chemikalienbeständig gemacht und die Oberflächenrauigkeit wird reduziert. Die hierbei relevanten Bereiche der Oberfläche, auf die das Beschichtungsmaterial aufgebracht wird, sind insbesondere solche Bereiche, die später bei der Verwendung mit entsprechenden Medien oder Chemikalien in Berührung kommen und daher geschützt werden sollten. Dies betrifft insbesondere eine Oberseite (insbesondere die schon erwähnte ebene Fläche), die zum Ansaugen der Halbleiterwerkstücke dient. Bevorzugte Beschichtungsmaterialien sind dabei Polytetrafluorethylen, PTFE, Perfluoralkoxy-Polymer, PFA, Polyvinylidenfluorid, PVDF, DLC (diamond like carbon) oder Siliziumcarbid.

Der Grund für bevorzugte Verwendung einer solchen Beschichtung liegt darin, dass bei mittels eines additiven Aufbauverfahrens wie 3-D-Druck hergestellten Komponenten wie auch des erwähnten Vakuumgreifers (ggf. nur) aus dem Grundmaterial - je nach gewünschter Anwendung - ggf. die Rauheit der Oberflächen zu stark ausgeprägt ist, d.h. die Oberflächen weisen in der Regel eine zu starke Rauheit für die gewünschte Verwendung auf. Dadurch lagern sich organische und anorganische Verschmutzungen (die z.B. beim Polieren des mittels des Vakuumgreifers gehaltenen Halbleiterwerkstücks entstehen) an den Oberflächen ein und an und beeinflussen unter Umständen die Qualität der zu bearbeitenden Halbleiterwerkstücke negativ.

Durch die Beschichtung mit z.B. PTFE auf den relevanten Oberflächen eines mittels eines additiven Aufbauverfahrens hergestellten Vakuumgreifers ist es nunmehr jedoch möglich, die positiven Eigenschaften eines auf herkömmliche Art hergestellten Vakuumgreifers (also insbesondere die Chemikalienbeständigkeit) mit den positiven Eigenschaften eines mittels eines additiven Aufbauverfahrens hergestellten Vakuumgreifers für Siliziumwafer (also insbesondere die freie Formgebung) zu verbinden.

Da ein mittels eines additiven Aufbauverfahrens hergestellter Vakuumgreifer bei herkömmlichen Beschichtungsverfahren thermisch stark belastet wird und sich dadurch verformen würde, kann gezielt ein Niedertemperatur-Beschichtungsverfahren in Kombination mit dem additiven Aufbauverfahren verwendet werden. Herkömmlicherweise werden die für die Prozesse bei Halbleiterwerkstücken erforderlichen High-Purity-Beschichtungen (also Beschichtungen von besonders hoher Reinheit) bei hohen Temperaturen auf Oberflächen aufgebracht.

Durch ein gezielt eingesetztes Niedertemperatur-Beschichtungsverfahren, bevorzugt mit einer Temperatur unterhalb von 150°C, lassen sich High-Purity-Beschichtungen auch auf die weniger temperaturstabilen Oberflächen von z.B. 3-D- gedruckten Komponenten wie dem Vakuumgreifer aufbringen und somit die Vorteile wie freie Formgebung, gezielte Positionierung von Ansaugöffnungen und die chemischen und physikalischen Eigenschaften zusammenführen. Beispielsweise weist das Material PA 3200GF eine Formbeständigkeitstemperatur (bei einem Druck von 0,45 MPa und in X-Richtung) von max. 157°C nach ISO 75-1/-2 auf. Vergleichbares gilt für die bevorzugten Grundmaterialien, die ein Polyamid, insbesondere gefüllt mit Glaskugeln, aufweisen. Wird diese Temperatur überschritten, fällt die plastische Kontur typischerweise in sich zusammen. PTFE-Beschichtungen z.B. werden in der Regel aufgespritzt und in einem Ofen bei einer Temperatur von etwa 220°C bis 420°C gesintert. Durch ein Nieder-Temperatur-Sinterverfahren, das sich typischerweise über einen längeren Zeitraum bei z.B. 100°C erstreckt, konnte erreicht werden, einen 3-D-gedruckten Vakuumgreifer für Silizium-Wafer chemie- und schmutzresistent zu machen.

Eine Oberflächenrauigkeit der mittels eines additiven Aufbauverfahrens hergestellten Vakuumgreifer lässt sich durch Niedertemperatur-Beschichtungen reduzieren - typischerweise lassen sich die Rz- und Ra-Werte (die die Rauheit spezifizieren) um ca. 70 % gegenüber den entsprechenden Werten des Vakuumgreifers ohne die Niedertemperatur-Beschichtung reduzieren. Dies trägt damit auch dazu bei, dass Partikel oder andere organische oder anorganische Bestandteile der Flüssigkeiten am Vakuumgreifer deutlich weniger an den Oberflächen (des Vakuumgreifers) anhaften und dadurch deutlich leichter und gezielt entfernt werden können.

Mittels eines additiven Aufbauverfahrens bzw. mittels 3-D-Druck lassen sich gegenüber konventionellen Herstellungsverfahren in vielerlei Hinsicht optimierte Vakuumgreifer herstellen. Durch verbesserte Formgebung, d.h. die tatsächlich herstellbare Form kann besser an eine optimale Form heranreichen als mit herkömmlichen Herstellungsverfahren, können gegenüber herkömmlich angefertigter Vakuumgreifer z.B. die aktiv wirksamen Ansaugöffnungen, beispielsweise in Form von Saugtrichtern, der jeweils gewünschten Anwendung angepasst werden. Durch die freie Formgebung lässt sich die notwendige, durch das Vakuum bzw. den Unterdruck erzeugte Haltekraft besonders genau einstellen. Der zu evakuierende Bereich (Kanäle) kann durch die anwendungsoptimierte und variable Formgebung möglichst geringgehalten werden, was zu einem schnelleren Auf- und Abbau der Haltekräfte beiträgt und dadurch z.B. den Transfer der Halbleiterwerkstücke beschleunigt.

Anders als bei herkömmlichen Fertigungsverfahren, die durch die Verwendung von spanabhebenden Werkzeugen begrenzt sind, womit sich z.B. dünne Tieflöcher nur mit begrenzter Länge erzeugen lassen, kann durch das additive Herstellverfahren z.B. ein Vakuumreservoir direkt im Vakuumgreifer, z.B. durch örtlich größere Querschnitte der Kanäle innerhalb des Vakuumgreifers, hergestellt werden. Dadurch wird der Vakuumgreifer gegenüber kurzzeitigen Vakuumleckagen unempfindlicher und die Gefahr des Verlustes der Halbleiterwerkstücke bei Abfall der Haltekraft während der Oberflächenbearbeitung wird reduziert. Durch individuelle Gestaltung und Anordnung der Ansaugöffnungen und Ansaugkanäle lassen sich gegenüber herkömmlichen Herstellverfahren die Haltekräfte der Halbleiterwerkstücke gezielt einstellen, z.B. derart, dass sich im Randbereich während Bearbeitung höhere Haltekräfte einstellen, als in anderen Bereichen (was mit einer besonderen Krafteinwirkung auf die Werkstückkante einhergeht).

Das additive Herstellungsverfahren ermöglicht es, die Anzahl von Ansaugöffnungen und von Kanälen je nach Bereich des Vakuumgreifers gezielt zu wählen und so z.B. gegenüber herkömmlich hergestellten Vakuumgreifern die Anzahl von Ansaugöffnungen und Kanälen im Randbereich zu erhöhen, damit während der Bearbeitung der Halbleiterwerkstücke angesaugte Medien, z.B. Poliermittel, schneller abgesaugt werden können. Randverätzungen werden so vermieden.

Gegenüber herkömmlicher Herstellverfahren wird mit dem vorgeschlagenen Verfahren auch eine gezielt gestaltbare Formgebung der Ansaugöffnungen selbst, z.B. im Randbereich, ermöglicht, die den jeweiligen Bearbeitungsprozessen der Halbleiterwerkstücke angepasst werden können. Bei Bearbeitungsprozessen der Kanten der Halbleiterwerkstücke, z.B. Kantenpolieren, gelangen typischerweise Prozessmedien durch die Krafteinwirkung gegen die Kante auch in Bereiche zwischen dem Vakuumgreifer und der Halbleiterwerkstücke. Eine als Ringkanal an der Oberseite des Vakuumgreifers ausgeführte Ansaugöffnung ermöglicht z.B. den schnellen Abtransport der eingedrungenen Medien und dadurch eine Vermeidung von ungewollten chemischen oder physikalischen Reaktionen der Medien an den Oberflächen der Halbleiterwerkstücke.

Durch Verwendung des additiven Aufbauverfahrens lassen sich gegenüber den herkömmlichen Herstellverfahren von Vakuumgreifern z.B. auch flexible Dichtungen entweder direkt integrieren oder nachträglich anbringen, wie schon erwähnt. Die z.B. 3-D-gedruckten Dichtungselemente können - anders als bei herkömmlichen Dichtungen - exakt auf die Bearbeitungsprozesse der Halbleiterwerkstücke angepasst werden und verhindern dadurch, z.B. während Kantenpolierprozessen, das Eindringen von Prozessmedien im Randbereich zwischen Auflagefläche und Halbleiterwerkstück. Durch Verwendung solcher mittels additiven Aufbauverfahrens hergestellter Vakuumgreifer mit integrierter Dichtung oder separater, aber ebenfalls mittels additiven Aufbauverfahrens hergestellter Dichtungen lassen sich Anpassungen der Dichtungen an geänderte Bearbeitungsprozesse der Halbleiterwerkstücke gegenüber herkömmlichen Herstellverfahren variabler und schneller realisieren.

Durch gezielte Anfertigung mittels additiver Aufbauverfahren können, anders als bei herkömmlichen Herstellverfahren, Ansaugöffnungen mit beliebiger Formgebung realisiert werden. Dadurch lassen sich z.B. scharfkantige Übergänge, z.B. durch Radien statt Fräskanten, an den beliebig geformten Ansaugöffnungen und Auflageflächen der Halbleiterwerkstücke vermeiden. Die scharfkantigen Übergänge bei herkömmlich hergestellten Vakuumgreifern sind eine wesentliche Ursache für Abdrücke, Kratzer oder anderer Beschädigungen an den Oberflächen der Halbleiterwerkstücke, da durch das Evakuieren die Oberfläche gegen die Auflagefläche gedrückt wird und scharfkantige Übergänge aufgrund der hohen Haltekräfte, die z.B. bei der Kantenpolitur erforderlich sind, Abdrücke (sog. "Chuck Marks") am Halbleiterwerkstück bzw. Wafer erzeugen.

Gegenüber herkömmlich hergestellter Vakuumgreifer, z.B. durch spanabhebende Verfahren, lassen sich mittels eines additiven Aufbauverfahrens z.B. optimierte Kanäle bzw. Kanalführungen und Ansaugöffnungen realisieren. Das trägt dazu bei, dass bei zeitlich begrenzten Vakuumleckagen, die z.B. aufgrund der Polierkräfte und des Anhebens der Kanten der Halbleiterwerkstücke entstehen, eine ausreichende Haltekraft zwischen Vakuum-Greifer und Halbleiterwerkstück erhalten bleibt. Weiterhin wird durch die variable Anordnung aktiver Halteelemente (also der Ansaugöffnungen) auf der Oberseite bzw. Haltefläche des Vakuumgreifers eine (möglichst) homogene Verteilung der im Prozess wirkenden Kräfte erreicht, somit wird die Substratbeanspruchung bei gleichbleibender Systemleistung geringgehalten und die Gefahr von Brüchen der Halbleiterwerkstücke (Waferbruch) sinkt erheblich.

Wie schon erwähnt, kann durch das Vorsehen einer Schicht aus Material mit geringerem Härtegrad als das Grundmaterial die Verwendung eines sog. "Chuck Pads" eingespart werden. Wenn eine solche Schicht nicht vorgesehen wird und/oder dennoch ein "Chuck Pad" verwendet werden soll, kann dessen Herstellung ebenfalls vereinfacht werden. Der Grund hierfür liegt darin, dass bei "Chuck Pads" für herkömmliche Vakuumgreifer in der Regel ringförmige Ausschnitte nötig sind, um die im Vakuumgreifer vorgesehenen Ansaugöffnungen freigeben zu können. Durch die deutlich variablere Gestaltung der Ansaugöffnungen im mittels additivem Aufbauverfahren hergestellten Vakuumgreifer können entsprechend auch die Ausschnitte im "Chuck Pad" einfacher gehalten werden, z.B. als kreisförmige Ausschnitte. Daneben ist es auch denkbar, ein "Chuck Pad" selbst mittels additivem Aufbauverfahren herzustellen.

Additive Aufbauverfahren bzw. 3-D-Druck ermöglichen - insbesondere im Vergleich zu bisher verwendeten Gussverfahren oder spanabhebenden Verfahren - eine Stückzahlunabhängigkeit, optimierten Materialeinsatz und geringere Werkzeugkosten. Dadurch sind die Herstellkosten der Vakuumgreifer im Vergleich zu herkömmlichen Herstellverfahren deutlich niedriger. Eine Modifikation z.B. zugrunde liegender 3D-CAD-Daten zur Steuerung des 3-D-Drucks können ausreichen, um ein verändertes Design der Vakuumgreifer herzustellen bzw. zu drucken, zusätzliche Werkzeuganfertigungen wie bei herkömmlichen Herstellverfahren, z.B. Gussmodelle, Spezial-Fräsköpfe, sind nicht nötig.

Wie schon erwähnt, ermöglicht ein additives Aufbauverfahren bzw. der 3-D-Druck eine freie Formgebung und dadurch z.B. auch eine gezielte Masseverteilung des verwendeten Materials bzw. Grundmaterials zur definierten Vermeidung von Schwingungen, die andernfalls z. B. durch Unwuchten hervorgerufen würden. Auch wird ein reduzierter Materialeinsatz erreicht, bei gleichbleibender mechanischer Steifigkeit, z.B. durch die Verwendung einer Wabenstruktur, massereduzierender Streben statt Vollmaterial und eines FEM ("Finite-Elemente-Methode") generierten und für die jeweilige Anwendung optimierten Designs. Weiterhin kann die Verwendung von Füllstoffen zur gezielten Einstellung mechanischer Eigenschaften in Betracht gezogen werden. Vorzugsweise lassen sich in diesem Zussammenhang z.B. Faseranteile wie Karbonfaser, Glasfaser oder Keramikfaser zur gezielten Einstellung der Steifigkeit, die bei dem additiven Aufbauverfahren auch innerhalb des Vakuumgreifers Unterschiede aufweisen kann, verwenden. So kann der Vakuumgreifer z.B. an mechanischen Befestigungsstellen verschleißfester als am Rand ausgebildet werden.

Wie ebenfalls schon erwähnt, können Additive zur gezielten Anpassung der Materialhärte verwendet werden, die bei additiven Aufbauverfahren ebenfalls variabel einstellbar ist. Dadurch lassen sich z.B. bestimmte Bereiche des Vakuum-Greifers flexibel, z.B. als Dichtung, herstellen, andere Bereiche wiederum z.B. fester und steifer.

Anders als bei herkömmlichen Herstellverfahren lassen sich bei additiven Aufbauverfahren bzw. beim 3-D-Druck unterschiedliche Materialien ohne Fügetechnik kombinieren, womit für die jeweilige Anwendung bestimmte, erforderliche Eigenschaften realisiert werden können. Bevorzugt lassen sich dadurch Wirkmechanismen durch Materialkombinationen erzielen, die bei herkömmlich hergestellten Vakuumgreifern nur durch zusätzlich Aktuatoren realisiert werden können. Beispielsweise lassen sich bei 3-D-Druckverfahren die Randbereiche der Vakuumgreifer mit elastischen und federnden Materialien herstellen, die den Randbereich bei der Kantenpolitur besser abstützen.

Zudem kann bevorzugt eine anwendungsspezifische Glättung bestimmter Bereiche wie z.B. der Oberflächen des Vakuumgreifers durch spezielle Schleifverfahren, insbesondere mittels Ultraschalles und Schleifadditiven, erreicht werden, die zweckmäßigerweise an allen Oberflächen des Vakuumgreifers, auch der innenliegenden Kanäle, die Oberflächenrauigkeit reduzieren. Dies führt zu einer reduzierten Anhaftung von Medien, z.B. Poliermittel, an Oberflächen und dadurch zur Vermeidung von Beschädigungen der Halbleiterwerkstücke.

Die Erfindung betrifft außerdem einen Vakuumgreifer für Halbleiterwerkstücke, der zumindest aus einem Grundmaterial mittels eines additiven Aufbauverfahrens hergestellt ist, insbesondere in bzw. mit einer vorgegebenen Form. Der Vakuumgreifer weist dabei zweckmäßigerweise eine zumindest im Wesentlichen ebene Fläche, auf der ein Halbleiterwerkstück anordenbar ist, eine oder mehrere Ansaugöffnungen und einen oder mehrere damit verbundene Kanäle auf. Ein solcher Vakuumgreifer ist dabei bevorzugt mittels eines erfindungsgemäßen Verfahrens hergestellt. Hinsichtlich weiter bevorzugter Ausgestaltungen und Vorteile sei zur Vermeidung von Wiederholungen auf vorstehenden Ausführungen zum Verfahren verwiesen, die hier entsprechend gelten.

Weitere Vorteile und Ausgestaltungen der Erfindung ergeben sich aus der Beschreibung und der beiliegenden Zeichnung.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand eines Ausführungsbeispiels in der Zeichnung schematisch dargestellt und wird im Folgenden unter Bezugnahme auf die Zeichnung beschrieben.

### Figurenbeschreibung

- **Figur 1**: zeigt schematisch einen Ablauf eines erfindungsgemäßen Verfahrens in einer bevorzugten Ausführungsform.
- **Figur 2**: zeigt schematisch einen erfindungsgemäßen Vakuumgreifer in einer bevorzugten Ausführungsform.
- **Figur 3**: zeigt den Vakuumgreifer aus **Figur 2** in einer Schnittansicht.
- **Figur 4**: zeigt einen vergrößerten Ausschnitt aus **Figur 3****.**
- **Figur 5**: zeigt schematisch einen erfindungsgemäßen Vakuumgreifer in einer weiteren bevorzugten Ausführungsform.
- **Figur 6**: zeigt schematisch einen erfindungsgemäßen Vakuumgreifer in einer weiteren bevorzugten Ausführungsform.
- **Figur 7**: zeigt den Vakuumgreifer aus **Figur 6** in einer anderen Ansicht.
- **Figur 8**: zeigt eine andere Ansicht des in **Figur 7** gezeigten Vakuumgreifers

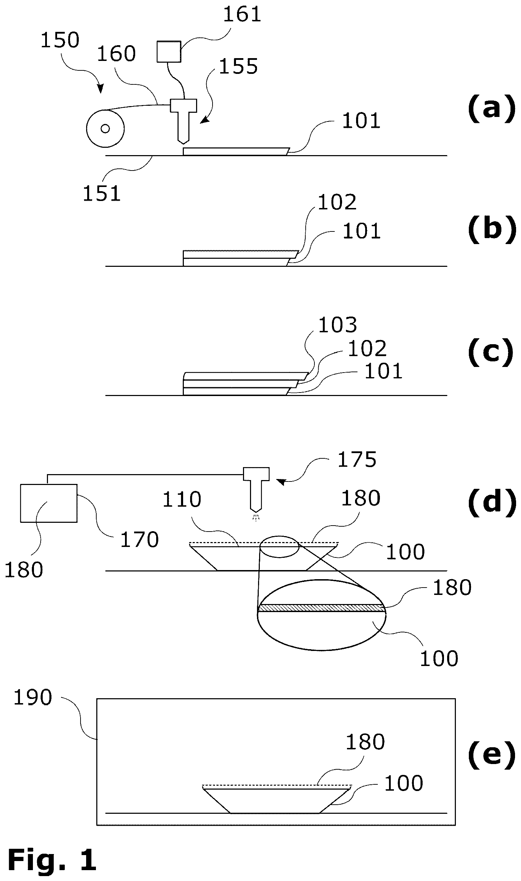

In **Figur 1** ist schematisch ein Ablauf eines erfindungsgemäßen Verfahrens in einer bevorzugten Ausführungsform dargestellt. Hierzu ist zunächst in Abbildung (a) grob schematisch eine Vorrichtung 150 für additives Aufbauverfahren, z.B. ein 3-D-Drucker, dargestellt, die einen Druckkopf 155 aufweist, dem ein Grundmaterial 160 zugeführt wird. Optional kann dem Druckkopf 155 auch ein Additiv 161 und/oder ein anderes Material (das dann insbesondere getrennt von dem Grundmaterial verwendet wird) zugeführt werden. Mittels des Druckkopfes 155 wird dann zunächst eine erste Schicht 101 des herzustellenden Vakuumgreifers auf einen Träger 151 aufgebracht.

Im weiteren Verlauf werden weitere Schichten aufgebracht, und zwar indem jeweils eine neue Schicht auf die jeweils vorhergehende Schicht aufgebracht wird. Beispielhaft sind in Abbildung (b) eine weitere Schicht 102, die auf die Schicht 101 aufgebracht wird, und in Abbildung (c) eine weitere Schicht 103, die auf die Schicht 102 aufgebracht wird, gezeigt.

Auf diese Weise wird der Vakuumgreifer 100 aus dem Grundmaterial mittels eines additiven Aufbauverfahrens in einer gewünschten bzw. vorgegebenen Form hergestellt, wie er grob schematisch in Abbildung (d) gezeigt ist. Für detailliertere Ansichten sei an dieser Stelle auf die noch folgenden Figuren verwiesen. Wie ebenfalls in Abbildung (d) gezeigt, wird z.B. auf die Oberseite des Vakuumgreifers 100 ein Beschichtungsmaterial 180 aufgebracht, beispielsweise mittels eines Auftragungswerkzeuges 175, dem das Beschichtungsmaterial 180 aus einem Tank 170 zugeführt wird.

Der auf diese Weise beschichtete Vakuumgreifer 100 wird dann z.B. in einem Ofen 190, wie in Abbildung (e) gezeigt, für eine vorbestimmte Zeitdauer innerhalb eines vorbestimmten Temperaturbereichs, der unterhalb einer Formbeständigkeitstemperatur des Grundmaterials 160 liegt, z.B. bei 150°C, getrocknet, insbesondere gesintert. Auf diese Weise entsteht ein fertiger, beschichteter Vakuumgreifer, der damit auch chemikalienbeständig ist.

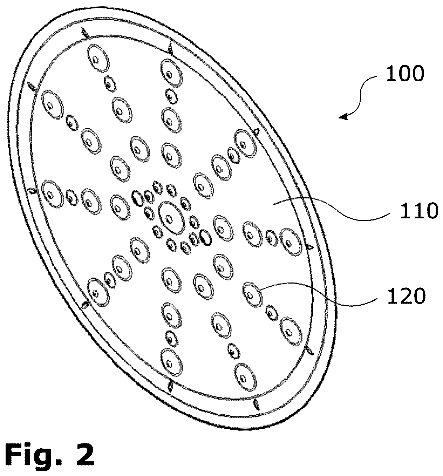

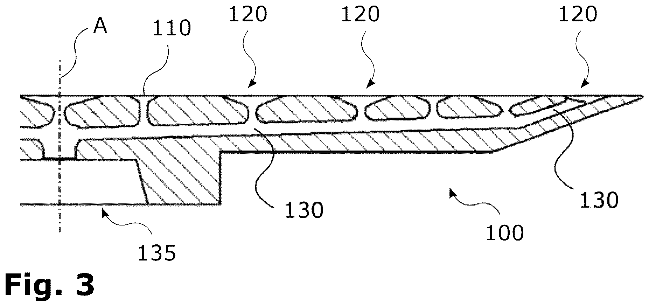

In **Figur 2** ist schematisch ein erfindungsgemäßer Vakuumgreifer 100 in einer bevorzugten Ausführungsform dargestellt, wie er beispielsweise mittels des in **Figur 1** gezeigten und in Bezug darauf beschriebenen Verfahrens hergestellt werden kann. Während **Figur 2** eine perspektivische Ansicht auf die Oberseite des Vakuumgreifers 100 zeigt, ist in **Figur 3** eine hierzu passende Schnittansicht gezeigt. Die in **Figur 3** gezeigte Symmetrieachse A verläuft in der Ansicht in **Figur 2** durch die zentrale Öffnung. Die **Figuren 2** und **3** sollen nachfolgend übergreifend beschrieben werden.

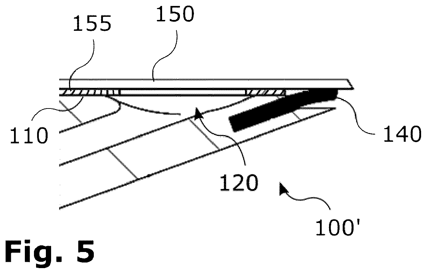

Der Vakuumgreifer 100 weist eine - in Bezug zur Symmetrieachse A - runde Form auf, mit einer Oberseite, die - zumindest im Wesentlichen - eine ebene Fläche 110 aufweist bzw. als eine solche ausgebildet ist. Auf diese ebene Fläche 110 wird bei Verwendung des Vakuumgreifers 100 - mittelbar oder unmittelbar - ein Halbleiterwerkstück wie z.B. ein Wafer aufgelegt. Hierzu sei auch auf **Figur 5** verwiesen.

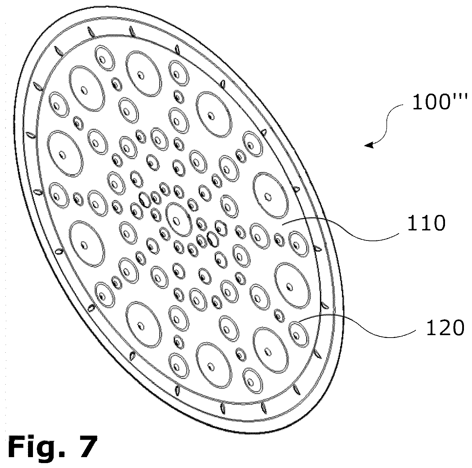

Auf der Oberseite des Vakuumgreifers 100 sind eine Vielzahl von Ansaugöffnungen 120 eingebracht. Während in **Figur 2** die - insbesondere gleichmäßige - Verteilung dieser Ansaugöffnungen 120 auf der Oberseite bzw. innerhalb der ebenen Fläche 110 zu sehen ist, zeigt **Figur 3** die Ausgestaltung innerhalb des Vakuumgreifers. Die Ansaugöffnungen 120 verengen sich, beginnend an der Oberseite, in etwa konisch zum Inneren des Vakuumgreifers 100 hin und münden dann in einen Kanal 130. Jede der Ansaugöffnungen 120 kann an einen Kanal 130 angebunden sein, wobei insbesondere die auf einer Linie in radialer Richtung liegenden Öffnungen an einen gemeinsamen Kanal 130 angebunden sind. Hierzu sei auch auf **Figur 7** verwiesen.

Der Kanal 130 und auch sämtlichen weiteren Kanäle münden im Zentrum bzw. auf der Symmetrieachse A in eine Öffnung 135, die der Oberseite bzw. ebenen Fläche 110 gegenüber liegt. Dort kann dann z.B. eine geeignete Apparatur angesetzt werden, um einen Unterdruck bzw. ein Vakuum zu erzeugen, der bzw. das sich durch die Kanäle 130 bis zu den Ansaugöffnungen 120 ausbreitet. Somit kann an den Ansaugöffnungen 120 ein Unterdruck bzw. ein Vakuum erzeugt werden, wodurch ein auf der ebenen Fläche 110 anliegender Wafer an die ebene Fläche 110 bzw. den Vakuumgreifer 100 angesaugt und damit in Position gehalten wird.

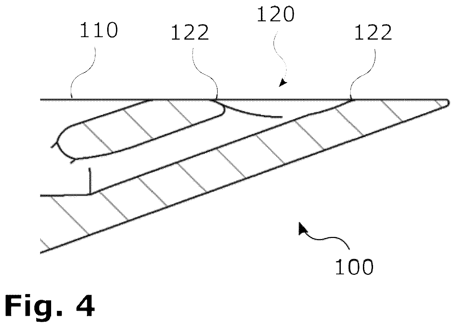

In **Figur 4** ist ein vergrößerter Ausschnitt des Vakuumgreifers 100 aus **Figur 3** gezeigt. Am Beispiel der dort ganz rechts, also radial ganz außen, gelegenen Ansaugöffnung 120 sind die Übergänge 122 der Ansaugöffnung 120 am Übergang zur ebenen Fläche 110 dargestellt. Hierbei ist zu sehen, dass diese nicht - wie dies bei herkömmlich hergestellten Vakuumgreifern der Fall wäre - scharfe Kanten sind, sondern vielmehr rundlich bzw. als Radien ausgebildet sind. Diese lassen sich mittels additivem Aufbauverfahren besonders gut bzw. einfach erzeugen und führen dazu, dass dort keine Beschädigungen eines anliegenden Wafers auftreten können oder zumindest sehr deutlich reduziert werden können.

In **Figur 5** ist schematisch ein erfindungsgemäßer Vakuumgreifer 100' in einer weiteren bevorzugten Ausführungsform dargestellt. Der Vakuumgreifer 100' entspricht im Grunde dem Vakuumgreifer 100 gemäß der **Figuren 2**, **3** und **4**. Die hier gezeigte Ansicht entspricht der in **Figur 4** gezeigten Ansicht.

Hierbei ist zu sehen, dass an dem radial äußeren Ende des Vakuumgreifers 100' eine Dichtung 140 eingebracht ist. Diese kann insbesondere flexibel sein und z.B. in einem oder in mehreren Stücken um den Umfang des Vakuumgreifers herum verlaufen. Die Dichtung 140 kann z.B. ebenfalls mittels des additiven Aufbauverfahrens hergestellt werden, wozu dann aber bevorzugt ein anderes Material als das Grundmaterial verwendet wird.

Weiterhin ist auf der Oberseite bzw. der ebenen Fläche 110 ein Pad 155 - bzw. ein sog. "Chuck Pad" aufgebracht oder aufgelegt, auf das wiederum ein als Wafer ausgebildetes Halbleiterwerkstück 150 aufgelegt ist. Durch die Ansaugöffnungen und z.B. geeignete Öffnungen im Pad 155 (eine davon ist im Bereich der Ansaugöffnung 120 zu sehen) kann der Wafer 150 zusammen mit dem Pad 155 angesaugt werden. Ebenfalls ist zu sehen, dass der Wafer 150 mit der Dichtung 140 in Kontakt steht, wodurch eine Abdichtung erzeugt wird, sodass der Unterdruck eine höhere Wirkung erzielen kann.

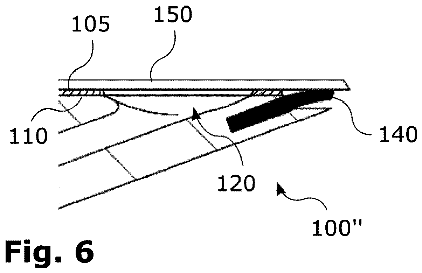

In **Figur 6** ist schematisch ein erfindungsgemäßen Vakuumgreifer 100" in einer weiteren bevorzugten Ausführungsform dargestellt. Der Vakuumgreifer 100" entspricht im Grunde dem Vakuumgreifer 100' wie er z.B. in **Figur 5** dargestellt ist, allerdings ist eine Schicht 105 auf der dem Wafer 150 zuzuwendenden Seite des Vakuumgreifers ausgebildet, die als "Chuck Pad" dient. Ein separates "Chuck Pad" ist daher nicht nötig.

In **Figur 7** ist schematisch ein erfindungsgemäßen Vakuumgreifer 100‴ in einer weiteren bevorzugten Ausführungsform dargestellt, und zwar in einer perspektivischen Ansicht vergleichbar der Ansicht in **Figur 2**. Der Vakuumgreifer 100" entspricht dabei im Grunde dem Vakuumgreifer 100 gemäß **Figuren 2**, **3** und **4**, allerdings sind -wie im Vergleich mit **Figur 2** zu sehen - mehr Ansaugöffnungen 120 vorgesehen. Dies zeigt, dass die Ansaugöffnungen 120 je nach Bedarf vorgesehen werden können, um so z.B. die durch den Unterdruck an den Ansaugöffnungen erzeugte Anpresskraft möglichst gleichmäßig auf den Wafer bzw. dessen Fläche zu verteilen.

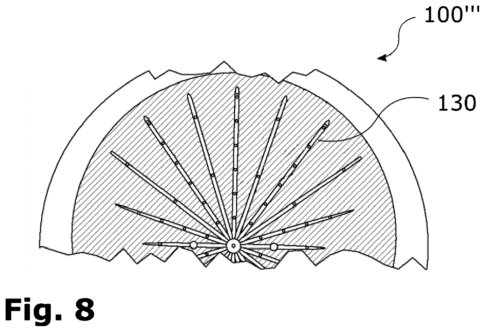

In **Figur 8** ist der Vakuumgreifer 100‴ aus **Figur 7** in einer anderen Ansicht gezeigt, nämlich mit einem Schnitt senkrecht zur Symmetrieachse (die wie bei dem Vakuumgreifer gemäß **Figur 2** liegt). Dort sind beispielhaft einige Kanäle 130 gezeigt, die in radialer Richtung verlaufen und sternförmig zentral zusammenlaufen. Mittels dieser Kanäle 130 kann jede der Ansaugöffnungen, wie sie z.B. in **Figur 7** zu sehen sind angeschlossen werden.

Der Schutzbereich des europäischen Patents wird durch die Patentansprüche bestimmt.

## Patentansprüche

1. Verfahren zum Herstellen einer Vorrichtung (100, 100', 100", 100‴), die geeignet ist mittels Vakuum ein Halbleiterwerkstück festzuhalten, bei der die Vorrichtung (100) aus zumindest einem Grundmaterial (160) mittels eines additiven Aufbauverfahrens, insbesondere eines 3-D-Drucks, erzeugt wird,
und die Vorrichtung (100, 100', 100", 100‴) derart ausgebildet wird, dass sie eine zumindest im Wesentlichen ebene Fläche (110), auf der ein Halbleiterwerkstück (150) anordenbar ist, eine oder mehrere Ansaugöffnungen (120) und einen oder mehrere damit verbundene Kanäle (130) aufweist
und die Vorrichtung (100', 100") derart ausgebildet wird, dass sie eine oder mehrere Dichtungen (140), insbesondere flexible Dichtungen, aufweist, die mit einem auf der Vorrichtung anzuordnenden Halbleiterwerkstück (150) in Kontakt bringbar ist oder sind
und die Vorrichtung (100, 100', 100', 100"") derart ausgebildet wird, dass sie Verstärkungsstrukturen umfasst, die insbesondere aus dem Grundmaterial (160) gebildet werden.

2. Verfahren nach Anspruch 1, wobei vorgegebene Bereiche der Vorrichtung (100, 100', 100", 100‴) aus einem anderen Material als dem Grundmaterial (160) mittels eines additiven Aufbauverfahrens, insbesondere eines 3-D-Drucks, erzeugt werden.

3. Verfahren nach einem der vorstehenden Ansprüche, wobei die Vorrichtung (100‴) auf einer dem Halbleiterwerkstück (150) zuzuwendenden Seite mit einer Schicht (105) aus einem Material ausgebildet wird, das einen geringeren Härtegrad als das Grundmaterial (160) aufweist.

4. Verfahren nach Anspruch 3, wobei das Beschichtungsmaterial (180) mittels eines Niedertemperatur-Beschichtungsverfahrens, insbesondere eines Niedertemperatur-Sinterverfahrens, bevorzugt mit einer Temperatur unterhalb von 150°C, aufgebracht wird.

5. Verfahren nach einem der vorstehenden Ansprüche, wobei die Vorrichtung (100, 100', 100", 100‴) zumindest an vorbestimmten Bereichen geglättet wird, insbesondere unter Anwendung von Ultraschall und unter Verwendung eines Schleifadditivs.

## Claims

1. Method for producing a device (100, 100', 100", 100") which is suitable for holding a semiconductor workpiece by means of vacuum, in which the device (100) is produced from at least one base material (160) by means of an additive assembly process, in particular 3-D printing,
and the device (100, 100', 100", 100") is designed in such a way that it has an at least essentially planar surface (110) on which a semiconductor workpiece (150) can be arranged, one or more suction openings (120) and one or more channels (130) connected thereto, and the device (100', 100") is designed in such a way in that it has one or more seals (140), in particular flexible seals, which can be brought into contact with a semiconductor workpiece (150) to be arranged on the device, and the device (100, 100', 100', 100"") is designed in such a way that it comprises reinforcing structures which are formed in particular from the base material (160).

2. The method according to claim 1, wherein predetermined areas of the device (100, 100', 100", 100‴) are generated from a material other than the base material (160) by means of an additive build-up process, in particular 3-D printing.

3. Method according to any of the preceding claims, wherein the device (100‴) is formed on a side facing the semiconductor workpiece (150) with a layer (105) of a material having a lower degree of hardness than the base material (160).

4. The method according to claim 3, wherein the coating material (180) is applied by means of a low-temperature coating process, in particular a low-temperature sintering process, preferably at a temperature below 150°C.

5. Method according to any of the preceding claims, wherein the device (100, 100', 100", 100‴) is smoothed at least at predetermined areas, in particular using ultrasound and using an abrasive additive.

## Revendications

1. Procédé de fabrication d'un dispositif (100, 100', 100", 100") qui est approprié pour maintenir une pièce à usiner semi-conductrice au moyen du vide, dans lequel le dispositif (100) est produit à partir d'au moins un matériau de base (160) au moyen d'un procédé de construction additive, en particulier d'une impression en 3-D,
et le dispositif (100, 100', 100", 100") est réalisé de telle sorte qu'il présente une surface (110) au moins essentiellement plane, sur laquelle une pièce à usiner semi-conductrice (150) peut être disposée, une ou plusieurs ouvertures d'aspiration (120) et un ou plusieurs canaux (130) reliés à celles-ci et le dispositif (100', 100") est réalisé de telle sorte, qu'il présente un ou plusieurs joints (140), en particulier des joints flexibles, qui peuvent être mis en contact avec une pièce à usiner semi-conductrice (150) à disposer sur le dispositif et le dispositif (100, 100', 100', 100"") est réalisé de telle sorte qu'il comprend des structures de renforcement qui sont formées en particulier à partir du matériau de base (160).

2. Procédé selon la revendication 1, dans lequel des zones prédéterminées du dispositif (100, 100', 100", 100"') sont produites à partir d'un matériau autre que le matériau de base (160) au moyen d'un procédé de construction additive, en particulier d'une impression 3D.

3. Procédé selon l'une quelconque des revendications précédentes, dans lequel le dispositif (100‴) est formé sur un côté faisant face à la pièce semi-conductrice (150) avec une couche (105) d'un matériau présentant un degré de dureté inférieur à celui du matériau de base (160).

4. Procédé selon la revendication 3, dans lequel le matériau de revêtement (180) est appliqué au moyen d'un procédé de revêtement à basse température, en particulier un procédé de frittage à basse température, de préférence avec une température inférieure à 150°C.

5. Procédé selon l'une quelconque des revendications précédentes, dans lequel le dispositif (100, 100', 100", 100‴) est lissé au moins sur des zones prédéterminées, notamment en utilisant des ultrasons et en utilisant un additif abrasif.
